# EUROPEAN PATENT APPLICATION

(11) **EP 4 482 251 A1**
(43) Date of publication of application: **25.12.2024**
(21) Application number: 23756039.6
(22) Date of filing: 11.01.2023
(51) Int. Cl.: H05B 6/68, H05B 6/64, H05B 6/66

(54) **OSCILLATOR AND ELECTRIC DEVICE**

(30) Priority: 18.02.2022 JP 2022024163
(71) Applicant: Panasonic Holdings Corporation, Osaka 571-8501 (JP)
(72) Inventor: SUGAYA Hidetaka, Osaka 571-0057 (JP); UNO Takashi, Osaka 571-0057 (JP); FUJIWARA Shozo, Osaka 571-0057 (JP); IKEDA Hikaru, Osaka 571-0057 (JP); FUJITA Shizuo, Osaka 571-0057 (JP); FUKUDA Katsutoshi, Osaka 571-0057 (JP)
(74) Representative: SSM Sandmair
(86) International application number: PCT/JP2023/000451
(87) International publication number: WO 2023/157511

(57) **Abstract**

An oscillator (1) according to the present disclosure generates output power, and provides a microwave that is in accordance with the output power as an output wave. The oscillator (1) includes a signal generator (10), a power amplifier (20), and a temperature sensor (40). The signal generator (10) generates an oscillation signal. The power amplifier (20) includes a final stage device (22), and amplifies the oscillation signal to generate the output power. The temperature sensor (40) detects a temperature of the final stage device (22). The final stage device (22) is packaged. The temperature sensor (40) is disposed in a package (200) that includes the final stage device (22).

## Description

### TECHNICAL FIELD

The present disclosure relates to an oscillator that generates output power, and provides, as output waves, microwaves that are in accordance with the output power, and relates to an electric device that includes the oscillator.

### BACKGROUND ART

Conventionally, a device is known which radiates microwaves to a heating target object (see, for example, Patent Literature (PTL) 1).

PTL 1 discloses a radio frequency (RF) energy radiation device that includes a cavity for accommodating a heating target object, a RF signal generator, a RF amplifier, and a temperature sensor. The RF signal generator oscillates radio frequency (RF) signals. The RF amplifier amplifies the RF signals, and outputs RF energy (microwaves). The temperature sensor is disposed in the vicinity of the RF amplifier.

### Citation List

### Patent Literature

[PTL 1] International Publication No. WO2020/050356

### SUMMARY OF THE INVENTION

In the RF energy radiation device disclosed in PTL 1, a difference may occur between the actual temperature of the RF amplifier and the temperature detected by the temperature sensor. This difference is due to an error in the absolute temperature value caused by the thermal resistance from the RF amplifier to the temperature sensor and the delay time until the heat generated by the RF amplifier is transmitted to the area around the temperature sensor.

An object of the present disclosure is to provide an oscillator and an electrical device capable of more accurately detecting the temperature of a final stage device in the RF amplifier.

An oscillator according to one aspect of the present disclosure generates output power, and provides, as an output wave, a microwave that is in accordance with the output power. The oscillator according to the aspect includes: a signal generator; a power amplifier; and a temperature sensor. The signal generator generates an oscillation signal. The power amplifier amplifies the oscillation signal to generate the output power. The power amplifier includes a final stage device. The final device is packaged. The temperature sensor is disposed in a package that includes the final stage device.

An electric device according to another aspect of the present disclosure includes: the oscillator; an antenna that radiates the output wave provided by the oscillator; and a cavity that accommodates a heating target object. The electric device according to the aspect is, for example, a microwave oven.

According to the present disclosure, the temperature of the final stage device can be detected more accurately and the generation of microwaves can be controlled more accurately.

### BRIEF DESCRIPTION OF THE DRAWINGS

FIG. 1 is a block diagram illustrating a configuration of an oscillator according to Embodiment 1 of the present disclosure.
FIG. 2 is a block diagram illustrating a configuration of an electrical device that includes the oscillator according to Embodiment 1.
FIG. 3 is a schematic diagram illustrating an arrangement of a final stage device and a temperature sensor in the oscillator according to Embodiment 1.
FIG. 4 is a schematic diagram illustrating an arrangement of a final stage device and a temperature sensor in an oscillator according to Variation 1 of Embodiment 1.
FIG. 5 is a schematic diagram illustrating an arrangement of a final stage device and a temperature sensor in an oscillator according to Variation 2 of Embodiment 1.
FIG. 6 is a block diagram illustrating a configuration of an oscillator according to Embodiment 2.
FIG. 7 is a block diagram illustrating a configuration of an oscillator according to Embodiment 3 of the present disclosure.
FIG. 8 is a schematic diagram illustrating an arrangement of a final stage device, a temperature sensor, and a switching unit in the oscillator according to Embodiment 3.
FIG. 9 illustrates a schematic diagram illustrating an example where the final stage device and the switching unit in the oscillator according to Embodiment 3 are disposed on a same integrated circuit (IC) chip.
FIG. 10 is a block diagram illustrating a configuration of an oscillator according to Embodiment 4 of the present disclosure.
FIG. 11 illustrates a relationship between temperature rise and reflected power stored in a storage in the oscillator according to Embodiment 4.

### DESCRIPTION OF EMBODIMENTS

### (Embodiment 1)

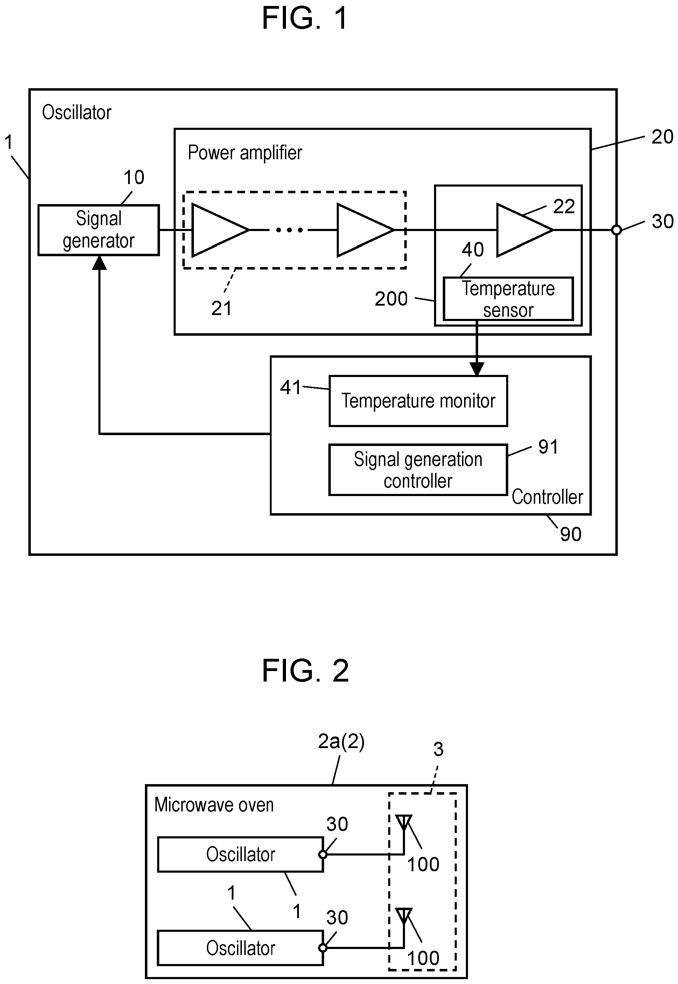

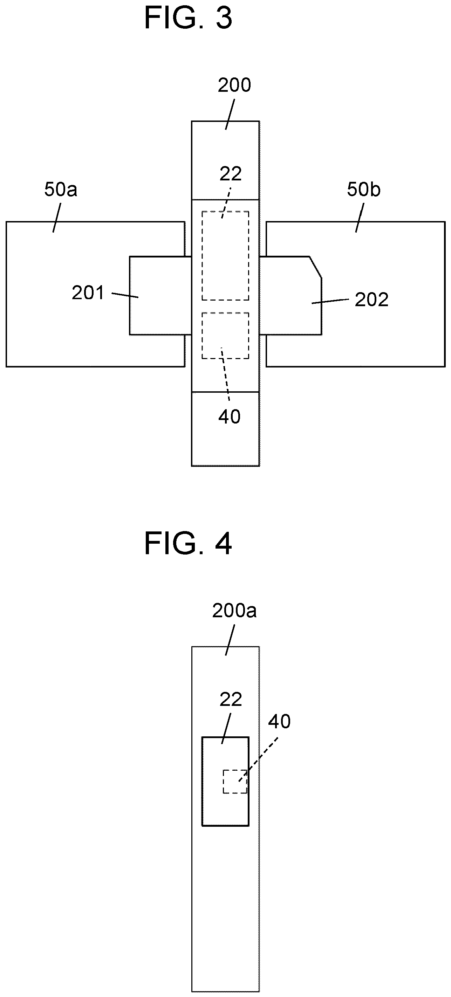

Oscillator 1 and electrical device 2 according to Embodiment 1 will be described below with reference to FIG. 1 to FIG. 3. FIG. 1 is a block diagram illustrating a configuration of oscillator 1 according to Embodiment 1. FIG. 2 is a block diagram illustrating a configuration of electric device 2 that includes oscillator 1 according to Embodiment 1. FIG. 3 is a schematic diagram illustrating an arrangement of final stage device 22 and temperature sensor 40 in oscillator 1 according to Embodiment 1.

### (1) Outline

Electric device 2 is microwave oven 2a that performs microwave heating on a heating target object such as woody biomass, ceramics, ceramic products, or food. Oscillators 1 are disposed inside microwave oven 2a, and provide microwaves.

As illustrated in FIG. 1, oscillator 1 includes signal generator 10, power amplifier 20, output terminal 30, and controller 90. Signal generator 10 generates and outputs an oscillation signal. Power amplifier 20 amplifies the oscillation signal to generate output power. Power amplifier 20 includes temperature sensor 40. Controller 90 controls signal generator 10.

Power amplifier 20 includes device group 21 and final stage device 22. Final stage device 22 and device group 21 are packaged separately. Temperature sensor 40 is disposed in the package that includes final stage device 22. With this configuration, the temperature of final stage device 22 can be detected more accurately by temperature sensor 40 disposed in the package that includes final stage device 22.

As illustrated in FIG. 2, microwave oven 2a includes oscillators 1, antennas 100, and cavity 3 for accommodating a heating target object. Antennas 100 radiate microwaves that are in accordance with the output power into cavity 3 as output waves.

In the present disclosure, each antenna 100 is an example of a structural element for radiating microwaves. However, in the present disclosure, the structural element for radiating microwaves is not limited to antenna 100. For example, when microwaves are transmitted through a waveguide, when microwaves are used in an electrocautery scalpel or hemostatic/affected area cauterization device, when microwaves are output via a coupler to an engine spark plug, etc., any configuration is possible as long as microwaves can be output or radiated as a radiator.

### (2) Specific Configuration

A configuration of microwave oven 2a and oscillator 1 according to Embodiment 1 will be described.

As illustrated in FIG. 2, microwave oven 2a includes one or more oscillators 1 (two oscillators 1 in FIG. 2) and one or more antennas 100 (two antennas in FIG. 2). Each of one or more antennas 100 corresponds to a different one of one or more oscillators 1. Microwave oven 2a includes cavity 3 for accommodating a heating target object.

One or more antennas 100 are all disposed in cavity 3. Oscillators 1 generate output power, and supply the output power to one or more antennas 100. Antennas 100 radiate microwaves that are in accordance with the output power into cavity 3 as output waves. This causes microwave oven 2a to heat a heating target object (e.g., food) accommodated in cavity 3.

In the present embodiment, each of one or more oscillators 1 corresponds to a different one of one or more antennas 100. However, the present disclosure is not limited to such a configuration. It may be that a plurality of oscillators 1 are disposed, and some or all of the outputs of the plurality of oscillators 1 are combined and supplied to antennas 100 which are fewer in number than oscillators 1.

Some of the outputs of one or more oscillators 1 may be distributed and supplied to antennas 100 which are larger in number than oscillators 1. A switch or the like may be disposed at the contact between oscillator 1 and antenna 100, and an antenna to which the oscillation signal from oscillator 1 is supplied may be selected.

Antennas 100 are not essential structural elements in the present disclosure. It may be that a waveguide is disposed to transmit the output power to cavity 3, and the waveguide radiates microwaves into cavity 3.

In FIG. 1, signal generator 10 is a semiconductor oscillator which is capable of controlling the frequency of an oscillation signal. Signal generator 10 includes, for example, a quadrature modulation circuit, and is capable of controlling the phase of the oscillation signal. In addition, signal generator 10 is capable of controlling the amplitude of the oscillation signal.

Frequency control of the oscillation signal is to generate an oscillation signal of any frequency in a given frequency band. Phase control of the oscillation signal is to change the phase of the oscillation signal. Amplitude control of the oscillation signal is to change the amplitude of the oscillation signal.

Signal generator 10 may be capable of performing all of the frequency control, the phase control, and the amplitude control, or at least one of the frequency control, the phase control, or the amplitude control.

Power amplifier 20 amplifies the oscillation signal from signal generator 10 to provide output power. Power amplifier 20 includes device group 21 that includes a plurality of devices, final stage device 22 that is disposed in the final stage of power amplifier 20, and temperature sensor 40. The plurality of devices included in device group 21 and final stage device 22 are, for example, transistors. Oscillator 1 is a so-called amplifying oscillator that includes device group 21 and final stage device 22.

Device group 21 is connected to signal generator 10 and final stage device 22. For example, final stage device 22 is a gallium oxide device of type α, β, ε, or κ. Final stage device 22 is connected to output terminal 30. Final stage device 22 further amplifies the oscillation signal amplified by device group 21, and supplies output power (microwaves) to antenna 100 via output terminal 30.

As illustrated in FIG. 3, final stage device 22 is included in package 200 that is a packaged electronic component. Package 200 is connected to electrical lines 50a and 50b. Electrical lines 50a and 50b are, for example, microstrip lines.

Electrical line 50a is connected to device group 21. Electrical line 50b is connected to output terminal 30. Terminal 201 of package 200 is connected to electrical line 50a. Terminal 202 of package 200 is connected to electrical line 50b.

The input terminal of final stage device 22 is connected to terminal 201. In other words, the input terminal of final stage device 22 is connected to electrical line 50a via terminal 201. The output terminal of final stage device 22 is connected to terminal 202. In other words, the output terminal of final stage device 22 is connected to electrical line 50b via terminal 202.

In the present disclosure, package 200 and packaging need not necessarily be covered with walls or encapsulated and mounted in plastic or the like. Package 200 and packaging include a configuration that is mounted on a printed circuit board or heat sink as a so-called bare chip.

Some of the plurality of devices included in device group 21 may be included in the package that includes final stage device 22.

Final stage device 22 is not limited to a gallium oxide (Ga₂O₃) device. Final stage device 22 may be a device that is formed of one of the followings: laterally diffused metal-oxide-semiconductor (LDMOS) transistors, gallium arsenide (GaAs), tin oxide (SnO₂), diamond (C), indium oxide (In₂O₃), germanium dioxide (GeO₂), tin germanium oxide (SnGeO₂), gallium indium oxide ((GaIn)₂O₃), gallium nitride (GaN), aluminum gallium oxide ((AlGa)₂O₃).

Power amplifier 20 may include a matching circuit that is disposed between signal generator 10 and device group 21 to provide impedance matching between signal generator 10 and device group 21. Power amplifier 20 may include a matching circuit that is disposed between device group 21 and final stage device 22 to provide impedance matching between device group 21 and final stage device 22.

Moreover, power amplifier 20 may include a matching circuit that is disposed between final stage device 22 and output terminal 30 to provide impedance matching between final stage device 22, output terminal 30, and a structural element connected via output terminal 30 (e.g., antenna 100).

Output terminal 30 is disposed between power amplifier 20 and antenna 100, and is connected to power amplifier 20 and antenna 100. Output terminal 30 outputs the output power (microwaves) from final stage device 22 of power amplifier 20 to antenna 100.

Final stage device 22 and temperature sensor 40 are included in package 200. Temperature sensor 40 detects the temperature of final stage device 22, and outputs the detected temperature to controller 90. Hereafter, the temperature of final stage device 22 detected by temperature sensor 40 may simply be referred to as the detected temperature.

Controller 90 is a computer system that includes a processor and memory. The computer system functions as controller 90 when the processor executes the program stored in the memory.

The program to be executed by the processor is recorded in the memory of the computer system in advance. However, the program may be recorded on a non-volatile recording medium, such as a memory card and provided, or provided through telecommunication lines such as the Internet.

Specifically, controller 90 includes the functions of temperature monitor 41 and signal generation controller 91. Temperature monitor 41 receives the temperature detected by temperature sensor 40, and monitors the detected temperature. Signal generation controller 91 causes signal generator 10 to perform at least one of frequency control, phase control, or amplitude control on the oscillation signal based on the temperature detected by temperature sensor 40 and received by temperature monitor 41.

Specifically, when the detected temperature is higher than or equal to a first threshold value, signal generation controller 91 causes signal generator 10 to stop generating oscillation signals. When the detected temperature is lower than the first threshold value and higher than or equal to a second threshold value, signal generation controller 91 causes signal generator 10 to perform at least one of frequency control, phase control, or amplitude control on the oscillation signal. In the present disclosure, the first threshold value and the second threshold value are predetermined values, and the second threshold value is lower than the first threshold value.

For frequency control, signal generation controller 91 causes signal generator 10 to change the frequency of the oscillation signal, for example, from the frequency fa to frequency fb that is lower than frequency fa. For phase control, signal generation controller 91 causes signal generator 10 to delay the phase of the oscillation signal. For amplitude control, signal generation controller 91 causes signal generator 10 to reduce the amplitude of the oscillation signal.

When the detected temperature is lower than the second threshold value, signal generation controller 91 causes signal generator 10 to generate an oscillation signal having a predetermined frequency, phase, and amplitude without any frequency control, phase control, or amplitude control.

Controller 90 may be included in oscillator 1 or in an external device. Controller 90 does not have to include temperature monitor 41. In this case, temperature monitor 41 is disposed outside controller 90, receives and monitors the temperature detected by temperature sensor 40, and transmits information about the detected temperature to controller 90.

In the present disclosure, the functions of controller 90 are performed by a single computer system. However, the functions of controller 90 may be performed by a plurality of computer systems. Controller 90 may be configured from hardware that includes one or more IC chips.

### (3) Operation

Next, an operation of oscillator 1 will be described.

Signal generator 10 generates an oscillation signal of frequency fa, and performs gain adjustment and the like on the generated oscillation signal. Power amplifier 20 amplifies the oscillation signal of frequency fa to generate output power. Antenna 100 radiates microwaves that are in accordance with the output power into cavity 3 as output waves.

Antenna 100 receives the reflected waves that return when a portion of the output waves is reflected within cavity 3. When the reflected power that is in accordance with the reflected waves received by antenna 100 is input to final stage device 22, the temperature of final stage device 22 increases. Temperature sensor 40 detects the temperature of final stage device 22, and outputs the detected temperature to temperature monitor 41.

Signal generation controller 91 causes signal generator 10 to generate an oscillation signal based on the temperature detected by temperature sensor 40. For example, signal generation controller 91 causes signal generator 10 to perform at least one of frequency control, phase control, or amplitude control on the oscillation signal based on the temperature detected by temperature sensor 40.

Specifically, when the detected temperature is higher than or equal to the first threshold value, signal generation controller 91 causes signal generator 10 to stop generating oscillation signals. When the detected temperature is lower than the first threshold value and higher than or equal to the second threshold value, signal generation controller 91 causes signal generator 10 to perform at least one of frequency control, phase control, or amplitude control on the oscillation signal. When the detected temperature is lower than the second threshold value, signal generation controller 91 causes signal generator 10 to generate an oscillation signal having a predetermined frequency, phase, and amplitude without any frequency control, phase control, or amplitude control.

### (4) Advantageous Effects

As described above, oscillator 1 generates output power for providing microwaves that are output waves. Oscillator 1 includes signal generator 10, power amplifier 20, and temperature sensor 40.

Signal generator 10 generates an oscillation signal. Power amplifier 20 amplifies the oscillation signal to generate output power. Temperature sensor 40 detects the temperature of the final stage device. Power amplifier 20 includes final stage device 22. Final stage device 22 is packaged. Temperature sensor 40 is disposed in package 200 that includes final stage device 22. For example, temperature sensor 40 is disposed in package 200 that includes final stage device 22.

As described above, in this configuration, temperature sensor 40 is disposed in package 200 that includes final stage device 22. This reduces an error between the actual temperature of final stage device 22 and the temperature detected by temperature sensor 40. The delay time between the occurrence of the temperature change in final stage device 22 and the detection of the temperature change in final stage device 22 by temperature sensor 40 is also reduced. In other words, temperature sensor 40 is capable of detecting the temperature of final stage device 22 more accurately.

In a conventional oscillator, a circulator and a termination resistor are disposed to prevent reflected power from entering the amplifier. One end of the termination resistor is connected to the circulator and the other end of the termination resistor is connected to ground. The circulator outputs, to antenna 100, the output power (microwaves) from the amplifier. The circulator outputs, to the termination resistor, the reflected power from antenna 100.

On the other hand, in oscillator 1 according to the present embodiment, temperature sensor 40 is capable of more accurately detecting the temperature of final stage device 22, and more accurately controlling output of the microwaves that are in accordance with the temperature rise of final stage device 22. Therefore, the circulator and the termination resistor can be omitted in the present embodiment. As a result, the size of oscillator 1 can be reduced compared to the conventional oscillator.

It is not essential that oscillator 1 does not include a circulator and a termination resistor. Oscillator 1 may include a circulator and a termination resistor. In this case, the temperature of final stage device 22 can be detected even more accurately.

Microwave oven 2a according to Embodiment 1 includes oscillators 1, antennas 100, and cavity 3. Cavity 3 accommodates a heating target object. Antennas 100 radiate the output power (microwaves) generated by oscillators 1 to the heating target object accommodated in cavity 3.

### (5) Variations

Variations of Embodiment 1 will be listed below. The following variations can be combined as appropriate with Embodiment 1 above.

### (5.1) Variation 1

In Embodiment 1, temperature sensor 40 is disposed in package 200 separately from final stage device 22. However, the present disclosure is not limited to this configuration.

FIG. 4 is a schematic diagram illustrating an arrangement of final stage device 22 and temperature sensor 40 in oscillator 1 according to Variation 1 of Embodiment 1. As illustrated in FIG. 4, in Variation 1, final stage device 22 and temperature sensor 40 are integrated into a single chip and included in package 200a. In other words, final stage device 22 and temperature sensor 40 are disposed within the same IC chip.

### (5.2) Variation 2

In Embodiment 1, temperature sensor 40 is disposed inside package 200. However, the present disclosure is not limited to this configuration.

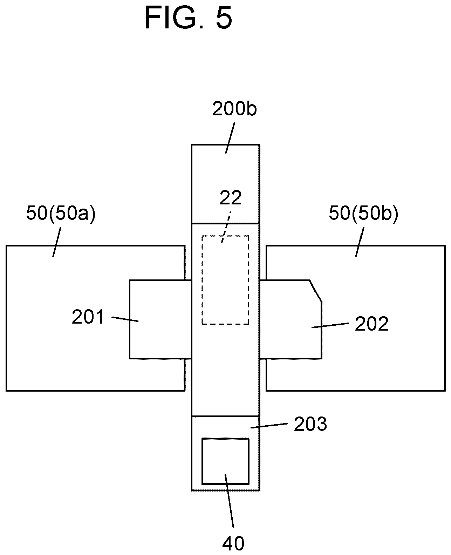

FIG. 5 is a schematic diagram illustrating an arrangement of final stage device 22 and temperature sensor 40 in oscillator 1 according to Variation 2 of Embodiment 1. In Variation 2, temperature sensor 40 may be disposed directly on the outer surface of package 200b according to Variation 2. For example, temperature sensor 40 in Variation 2 may be disposed directly on the surface of flange 203 of package 200b, as illustrated in FIG. 5.

In the present disclosure, "the temperature sensor is disposed in the package that includes the final stage device" includes not only the case where the temperature sensor is disposed inside the package, but also the case where the temperature sensor is directly disposed on the outer surface of the package.

### (5.3) Variation 3

In Embodiment 1, oscillator 1 is an amplifying oscillator. However, oscillator 1 may be a feedback oscillator that includes a single amplifier. When oscillator 1 is a feedback oscillator, one amplifier included in oscillator 1 corresponds to final stage device 22 in Embodiment 1.

### (5.4) Variation 4

In Embodiment 1, electric device 2 is microwave oven 2a. However, electric device 2 is not limited to microwave oven 2a.

Electric device 2 may be a dryer that uses microwaves in a washing machine, dishwasher, dryer, etc. Electric device 2 may be a liquid plasma generator, such as a sterilization device. Electric device 2 may be a material synthesizer that performs polymer synthesis, such as synthesis of foam material. Electric device 2 may be a microwave radiation device such as a medical device and a device that grow plants.

In addition, electric device 2 may be an accelerator, a semiconductor pulsed power supply, or an electron beam sterilizer. Electric device 2 may be a heating device that heats a catalytic device disposed inside a cavity attached to a vehicle that discharges exhaust gases to the outside.

### (5.5) Variation 5

In Embodiment 1, antenna 100 is not included in oscillator 1. However, antenna 100 may be included in oscillator 1.

### (5.6) Variation 6

Final stage device 22 may be a device whose temperature rise needs to be detected, e.g., a power device used in a power circuit.

### (Embodiment 2)

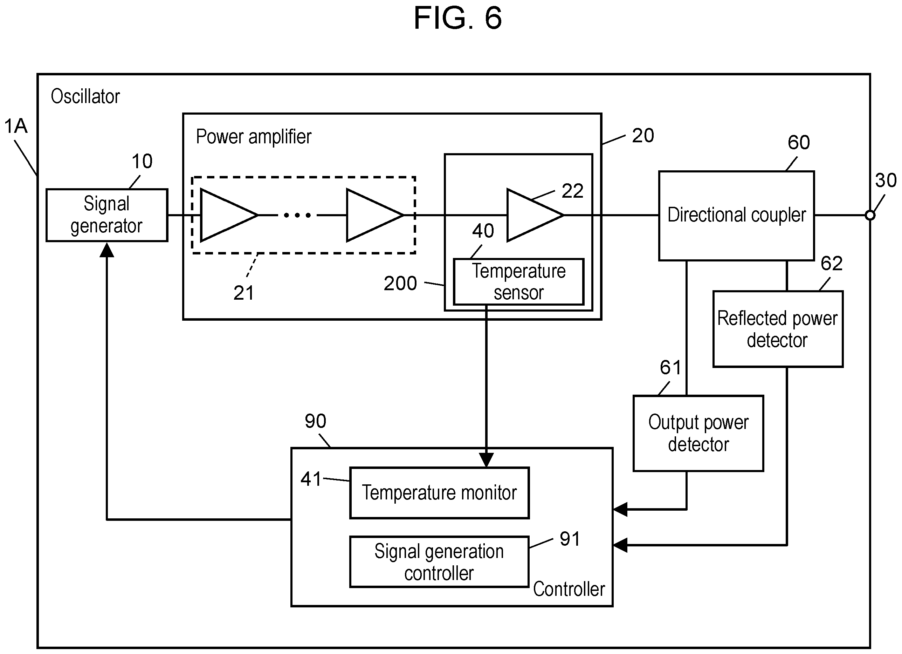

Embodiment 2 will be described below with reference to FIG. 6. In particular, the differences between the present embodiment and Embodiment 1 will be mainly described. In the present embodiment, the same structural elements as those in Embodiment 1 are marked with the same reference numerals, and the descriptions thereof may be omitted.

FIG. 6 is a block diagram illustrating a configuration of oscillator 1A according to Embodiment 2. As illustrated in FIG. 6, oscillator 1A further includes directional coupler 60, output power detector 61, and reflected power detector 62, in addition to the configuration of oscillator 1 according to Embodiment 1.

Directional coupler 60 is disposed between power amplifier 20 and output terminal 30 to provide, to antenna 100, the output power from final stage device 22. Along with that, directional coupler 60 branches a portion of the output power from power amplifier 20. Output power detector 61 detects the magnitude of the output power (microwaves) that passes through directional coupler 60 and is radiated from antenna 100, by detecting the power branched by directional coupler 60.

Directional coupler 60 receives the reflected waves received by antenna 100. Directional coupler 60 branches a portion of the reflected power received by antenna 100. Reflected power detector 62 detects the magnitude of the reflected power received by antenna 100 and passing through directional coupler 60, by detecting the reflected power branched by directional coupler 60.

In a similar manner to Embodiment 1, controller 90 includes the functions of temperature monitor 41 and signal generation controller 91. However, in Embodiment 2, signal generation controller 91 receives not only the temperature of final stage device 22 monitored by temperature monitor 41, but also the output power detected by output power detector 61 and the reflected power detected by reflected power detector 62. Signal generation controller 91 causes signal generator 10 to perform at least one of frequency control, phase control, or amplitude control on the oscillation signal based on the detected temperature, output power, and reflected power.

Specifically, at least one of when the detected temperature is higher than or equal to a first threshold value or when the reflectance is higher than or equal to a predetermined value, signal generation controller 91 causes signal generator 10 to stop generating oscillation signals. The term "reflectance" refers to the proportion of the reflected power that returns as reflected waves to the output power radiated as output waves. In other words, the reflectance is the proportion of the reflected power to the output power.

When the detected temperature is higher than or equal to the second threshold value and lower than the first threshold value, and when the reflectance is lower than the predetermined value, signal generation controller 91 causes signal generator 10 to perform at least one of frequency control, phase control, or amplitude control on the oscillation signal.

When the detected temperature is lower than the second threshold value, and when the reflectance is lower than the predetermined value, signal generation controller 91 causes signal generator 10 to generate an oscillation signal having a predetermined frequency, phase, and amplitude without any frequency control, phase control, or amplitude control.

Each variation of Embodiment 1 is applicable to Embodiment 2.

### (Embodiment 3)

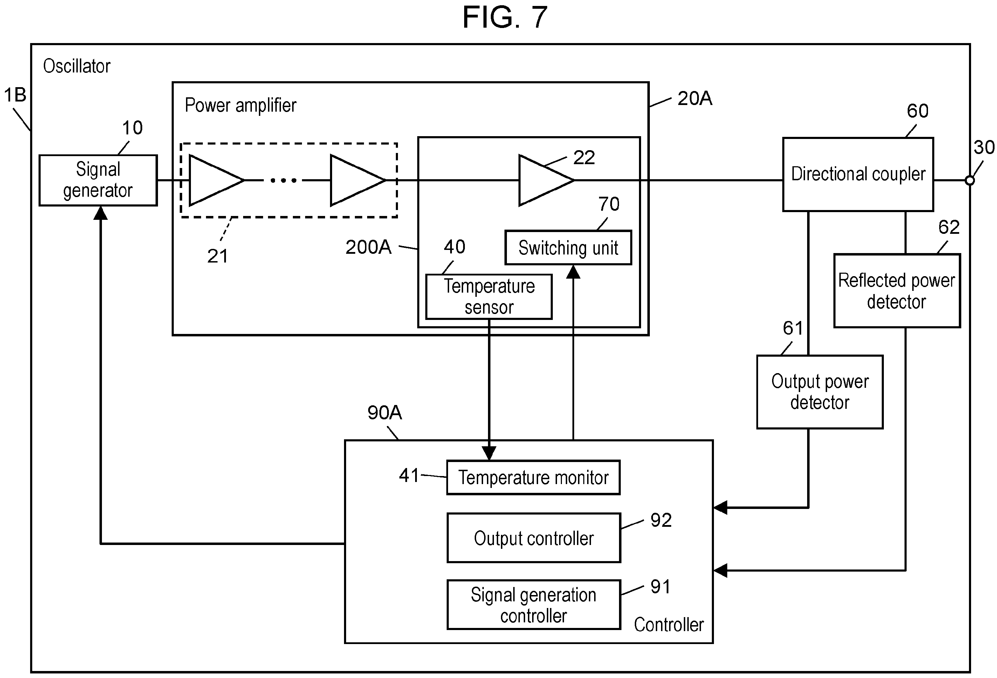

Embodiment 3 will be described below with reference to FIG. 7 to FIG. 9. In particular, the differences between the present embodiment and Embodiment 2 will be mainly described. In the present embodiment, the same structural elements as those in Embodiments 1 and 2 are marked with the same reference numerals, and the descriptions thereof may be omitted.

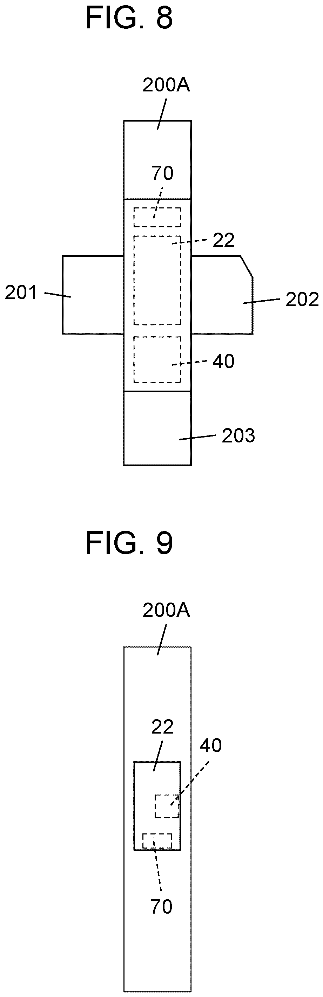

FIG. 7 is a block diagram illustrating a configuration of oscillator 1B according to Embodiment 3. FIG. 8 is a schematic diagram illustrating an arrangement of final stage device 22, temperature sensor 40, and switching unit 70 in oscillator 1B. FIG. 9 is a schematic diagram illustrating an example where final stage device 22 and switching unit 70 in oscillator 1B are disposed on the same IC chip.

As illustrated in FIG. 7, oscillator 1B includes power amplifier 20A instead of power amplifier 20, and controller 90A instead of controller 90. Power amplifier 20A further includes switching unit 70 in addition to device group 21, final stage device 22, and temperature sensor 40.

Switching unit 70 turns on or off the functions of final stage device 22. Specifically, switching unit 70 switches between connection and disconnection of the drive power to final stage device 22, for example. Instead of the above, switching unit 70 may connect or disconnect the electrical line between final stage device 22 and device group 21, or between final stage device 22 and directional coupler 60.

When final stage device 22 is turned on by switching unit 70, final stage device 22 further amplifies the oscillation signal amplified by device group 21 to provide output power (microwaves). Switching unit 70 is, for example, a logic circuit. Switching unit 70 is disposed in package 200A that includes final stage device 22 and temperature sensor 40. In Embodiment 3, switching unit 70 is disposed inside package 200A (see FIG. 8).

In addition to the functions of temperature monitor 41 and signal generation controller 91, controller 90A includes the functions of output controller 92. Output controller 92 controls switching unit 70 based on the temperature of final stage device 22 (detected temperature), the output power, and the reflected power.

For example, at least one of when the detected temperature is higher than or equal to the first threshold value or when the reflectance is higher than or equal to the predetermined value, output controller 92 causes switching unit 70 to turn off the functions of final stage device 22. When the detected temperature is lower than the first threshold value and when the reflectance is lower than the predetermined value, output controller 92 causes switching unit 70 to turn on the functions of final stage device 22.

Switching unit 70 may be integrated into a single chip with final stage device 22. In other words, switching unit 70 and final stage device 22 may be disposed within the same IC chip (see FIG. 9).

Each variation of Embodiment 1 is applicable to Embodiment 3. For example, when Variation 1 of Embodiment 1 is applied to Embodiment 3, switching unit 70, final stage device 22, and temperature sensor 40 are all integrated into a single chip (see FIG. 9). In other words, switching unit 70, final stage device 22, and temperature sensor 40 are disposed within the same IC chip.

When switching unit 70, final stage device 22, and temperature sensor 40 are disposed within the same chip, for example, temperature sensor 40 may be disposed in the central portion of the IC chip and switching unit 70 may be disposed at an end portion of the IC chip.

Switching unit 70 may be applied to oscillator 1 according to Embodiment 1. In this case, output controller 92 controls switching unit 70 based on the temperature of final stage device 22 (detected temperature) monitored by temperature monitor 41. For example, when the detected temperature is higher than or equal to the first threshold value, output controller 92 causes switching unit 70 to turn off the functions of final stage device 22. When the detected temperature is lower than the first threshold value, output controller 92 causes switching unit 70 to turn on the functions of final stage device 22.

### (Embodiment 4)

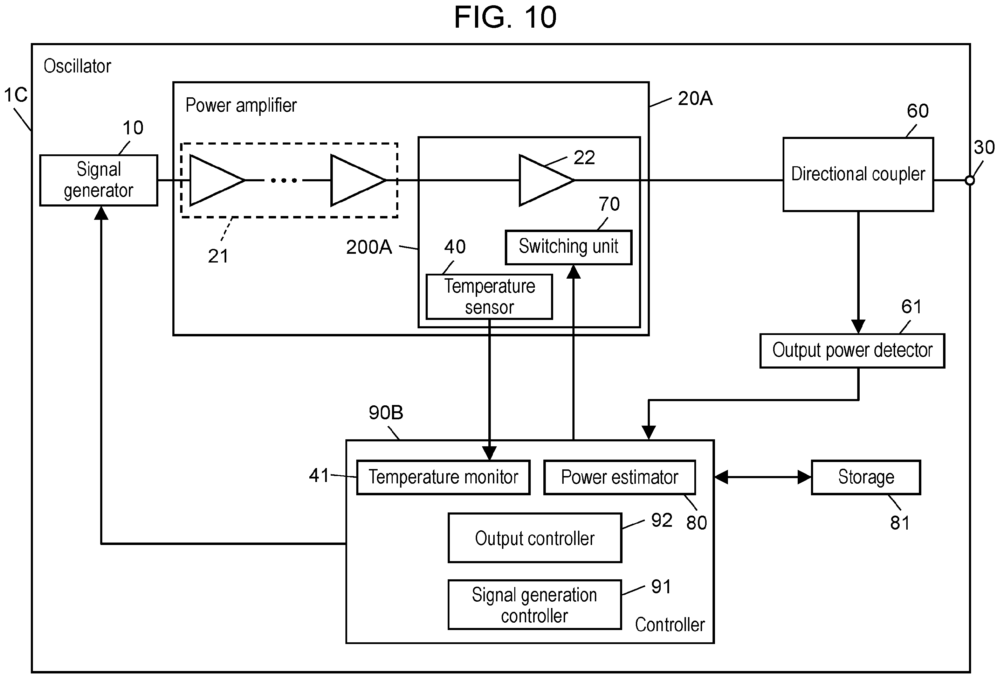

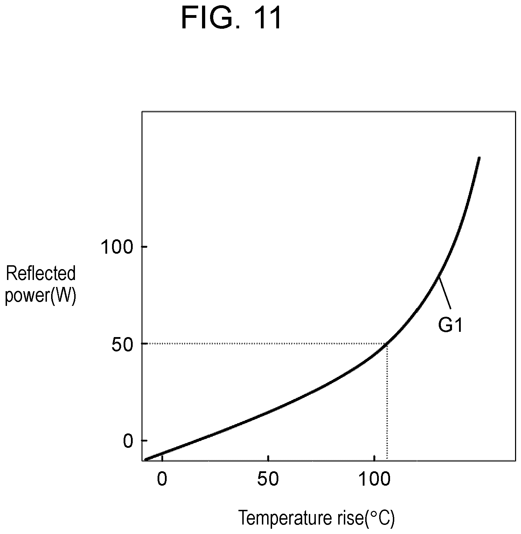

Embodiment 4 will be described below with reference to FIG. 10 and FIG. 11. In particular, the differences between the present embodiment and Embodiment 3 will be mainly described. In the present embodiment, the same structural elements as those in Embodiments 1 to 3 are marked with the same reference numerals, and the descriptions thereof may be omitted.

FIG. 10 is a block diagram illustrating a configuration of oscillator 1C according to Embodiment 4. FIG. 11 illustrates a relationship between temperature rise and reflected power stored in storage 81 in oscillator 1C.

As illustrated in FIG. 10, oscillator 1C does not include reflected power detector 62, but includes storage 81. Oscillator 1C further includes controller 90B instead of controller 90A. Controller 90B further includes the functions of power estimator 80, in addition to signal generation controller 91, output controller 92, and temperature monitor 41.

Storage 81 is configured from read only memory (ROM), random access memory (RAM), or electrically erasable programmable read only memory (EEPROM).

Stroage 81 stores relationship information that indicates the relationship between the reflected power and temperature rise of final stage device 22 with the output power detected by output power detector 61 as a parameter. The relationship information is, for example, graph G1 illustrated in FIG. 11. In FIG. 11, the horizontal axis represents temperature rise (°C) and the vertical axis represents reflected power (W).

The relationship information is not limited to graph G1. For example, the relationship information may be a table corresponding to graph G1, i.e., information that includes a plurality of sets in which reflected power and temperature rise are associated with each other. The relationship information may be an approximate formula that represents graph G1. The temperature of final stage device 22 is affected by the ambient temperature of oscillator 1. For this reason, storage 81 may have a plurality of approximate formulas that are in accordance with the ambient temperature.

Power estimator 80 estimates the reflected power received by antenna 100, using the temperature of final stage device 22 detected by temperature sensor 40 and the relationship information. Power estimator 80 calculates an increase in temperature of final stage device 22 (temperature rise) based on the two temperatures of final stage device 22 detected consecutively at a predetermined time interval. Power estimator 80 obtains (estimates) the value of reflected power corresponding to the calculated temperature rise, using the relationship information stored in storage 81.

In Embodiment 4, signal generation controller 91 receives the temperature of final stage device 22 (detected temperature) monitored by temperature monitor 41, the output power detected by output power detector 61, and the reflected power estimated by power estimator 80. Signal generation controller 91 causes signal generator 10 to perform at least one of frequency control, phase control, or amplitude control on the oscillation signal based on the detected temperature, output power, and reflected power.

Specifically, at least one of when the detected temperature is higher than or equal to the first threshold value or when the reflectance is higher than or equal to the predetermined value, signal generation controller 91 causes signal generator 10 to stop generating oscillation signals.

When the detected temperature is higher than or equal to the second threshold value and lower than the first threshold value, and when the reflectance is lower than a predetermined value, signal generation controller 91 causes signal generator 10 to perform at least one of frequency control, phase control, or amplitude control on the oscillation signal.

When the detected temperature is lower than the second threshold value and when the reflectance is lower than the predetermined value, signal generation controller 91 causes signal generator 10 to generate an oscillation signal having a predetermined frequency, phase, and amplitude without any frequency control, phase control, or amplitude control.

In Embodiment 4, output controller 92 controls switching unit 70 based on the detected temperature, the output power, and the reflected power estimated by power estimator 80. For example, at least one of when the detected temperature is higher than or equal to the first threshold value or when the reflectance is higher than or equal to the predetermined value, output controller 92 causes switching unit 70 to turn off the functions of final stage device 22.

When the detected temperature is lower than the first threshold value and when the reflectance is lower than the predetermined value, output controller 92 causes switching unit 70 to turn on the functions of final stage device 22.

When the input and output impedance differs from the characteristic impedance in directional coupler 60, the degree of coupling changes. Since oscillator 1C does not include a circulator nor a terminator, the output impedance of directional coupler 60 changes as the load impedance of the antenna changes.

The detection of the output power and the reflected power depends on the degree of coupling of directional coupler 60. Therefore, changes in the degree of coupling may reduce the detection accuracy of the output power and the reflected power. The degree of coupling of directional coupler 60 is almost unchanged by the output waves (microwaves). However, the reception of reflected waves may change the degree of coupling of directional coupler 60. This may reduce the detection accuracy of the reflected power by reflected power detector 62.

In order to prevent this, in Embodiment 4, the detected temperature is also used to accurately estimate the amount of reflected power, so that the detection accuracy of reflected power is improved. Moreover, the use of relationship information indicating the relationship between reflected power and temperature rise of final-stage device 22 can also prevent reduction of the detection accuracy of the reflected power.

In Embodiment 4, directional coupler 60 is not an essential structural element. The configuration may be such that oscillator 1C detects the output power and estimates the reflected power. For example, oscillator 1 according to Embodiment 1 may include output power detector 61, power estimator 80, and storage 81 according to Embodiment 4.

In Embodiment 4, controller 90 does not have to include temperature monitor 41 and power estimator 80. In this case, temperature monitor 41 and power estimator 80 are disposed outside controller 90.

Similarly in this case, temperature monitor 41 receives and monitors the temperature detected by temperature sensor 40, and transmits information about the detected temperature to controller 90. Power estimator 80 estimates the reflected power received by antenna 100 using the temperature of final stage device 22 detected by temperature sensor 40 and the relationship information, and transmits information about the reflected power to controller 90.

Oscillator 1A according to Embodiment 2 may include power estimator 80 and storage 81 in Embodiment 4 instead of reflected power detector 62.

Oscillator 1B according to Embodiment 3 may include output power detector 61, power estimator 80, and storage 81 according to Embodiment 4. Reflected power detector 62 is capable of increasing the detection accuracy of the reflected power.

Each variation of Embodiment 1 is applicable to Embodiment 4.

### (Conclusion)

As described above, the following aspects are disclosed in the description of the present application.

An oscillator (1; 1A; 1B; 1C) according to a first aspect generates output power for providing the microwaves that are output waves. The oscillator (1;1A;1B;1C) according to the present aspect includes a signal generator (10), a power amplifier (20), and a temperature sensor (40).

The signal generator (10) generates an oscillation signal. The power amplifier (20) amplifies the oscillation signal to generate output power. The power amplifier (20) includes a final stage device (22).

The final stage device (22) is packaged. The temperature sensor (40) is disposed in a package (200; 200a; 200b; 200A) that includes the final stage device (22).

With the configuration, the temperature sensor (40) disposed inside the package (200; 200a; 200b; 200A) that includes the final stage device (22) reduces an error between the actual temperature of the final stage device (22) and the temperature detected by the temperature sensor (40). The delay time between the occurrence of the temperature change in the final stage device (22) and the detection of the temperature change in the final stage device (22) by the temperature sensor (40) is also reduced. In other words, the temperature sensor (40) is capable of detecting the temperature of the final stage device (22) more accurately.

In the oscillator (1; 1A; 1B; 1C) according to the second aspect, in addition to the first aspect, the final stage device (22) and the temperature sensor (40) are integrated into a single chip.

With the configuration, the temperature of the final stage device (22) can be detected more accurately by including the final stage device (22) and the temperature sensor (40) within the same IC chip.

The oscillator (1A; 1B) according to the third aspect, in addition to the first aspect or the second aspect, further includes a directional coupler (60), an output power detector (61), and a reflected power detector (62).

The directional coupler (60) is positioned between the final stage device (22) and the output terminal (30) of the oscillator (1A; 1B). The directional coupler (60) outputs, to the output terminal (30), the output power provided by the final stage device (22), and receives reflected power that is in accordance with the reflected waves that return to the output terminal (30) among the output waves.

The output power detector (61) is connected to the directional coupler (60) to detect the output power. The reflected power detector (62) is connected to the directional coupler (60) to detect the reflected power.

With the configuration, the generation of the microwaves can be accurately controlled by detecting the output power and reflected power in addition to the temperature detected by the temperature sensor (40).

The oscillator (1B; 1C) according to the fourth aspect, in addition to the first aspect, further includes an output power detector (61), a storage (81), and a power estimator (80). The output power detector (61) detects the output power provided by the final stage device (22).

The storage (81) stores relationship information that indicates a relationship between the reflected power and a temperature rise of the final stage device (22) with the temperature of the final stage device (22) detected by the temperature sensor (40) and the output power detected by the output power detector (61) as parameters. The power estimator (80) estimates the value of the reflected power based on the relationship information.

With the configuration, it is possible to control the generation of the microwaves accurately.

The oscillator (IC) according to a fifth aspect, in addition to any one of the first to fourth aspects, further includes a signal generation controller (91). The signal generation controller (91) controls the signal generator (10). The signal generator (10) is operable to perform at least one of frequency control, phase control, or amplitude control on the oscillation signal.

The signal generation controller (91) causes the signal generator (10) to stop generation of the oscillation signal, or perform at least one of frequency control, phase control, or amplitude control on the oscillation signal.

With the configuration, it is possible to control the generation of the microwaves accurately by using at least the temperature detected by the temperature sensor (40).

The oscillator (1B; 1C) according to a sixth aspect, in addition to any one of the first to fifth aspects, further includes a switching unit (70). The switching unit (70) turns on or off the functions of the final stage device (22). The switching unit (70) is disposed in a package (200A).

With the configuration, it is possible to control the generation of the microwaves more accurately.

In the oscillator (1B; 1C) according to a seventh aspect, in addition to the sixth aspect, the switching unit (70), the final device (22), and the temperature sensor (40) are integrated into a single chip.

With the configuration, it is possible to detect the temperature of the final stage device (22) more accurately and to control the generation of the microwaves more accurately.

The oscillator (IC) according to an eighth aspect, in addition to the sixth aspect or the seventh aspect, further includes an output controller (92). The output controller (92) controls the switching unit (70) based on at least the temperature detected by the temperature sensor (40).

With the configuration, it is possible to control the generation of the microwaves more accurately.

In the oscillator (1; 1A; 1B; 1C) according to a ninth aspect, in addition to any one of the first to eight aspects, the final stage device (22) is a gallium oxide device.

An electric device (2) according to a tenth aspect includes: the oscillator (1; 1A; 1B; 1C) according to any one of the first to ninth aspects; an antenna (100) that radiates the output wave provided by the oscillator (1; 1A; 1B; 1C); and a cavity (3) that accommodates a heating target object. The electric device (2) according to the present aspect is, for example, a microwave oven (2a).

The microwave oven (2a) according to the configuration is capable of detecting the temperature of the final stage device (22) more accurately.

### INDUSTRIAL APPLICABILITY

In addition to microwave ovens, the oscillators according to the present disclosure are applicable to devices that use microwaves, such as dryers.

### REFERENCE MARKS IN THE DRAWINGS

1, 1A, 1B, 1C oscillator
2 electric device
2a microwave oven
3 cavity
10 signal generator
20, 20A power amplifier
21 device group
22 final stage device
30 output terminal
40 temperature sensor
41 temperature monitor
50a, 50b electrical line
60 directional coupler
61 output power detector
62 reflected power detector
70 switching unit
80 power estimator
81 storage
90, 90A, 90B controller
91 signal generation controller
92 output controller
100 antenna
200, 200a, 200b, 200A package
201,202 terminal
203 flange

## Claims

1. An oscillator that generates output power, and provides, as an output wave, a microwave that is in accordance with the output power, the oscillator comprising:
a signal generator that generates an oscillation signal;
a power amplifier that amplifies the oscillation signal to generate the output power; and
a temperature sensor,
wherein the power amplifier includes a final stage device,
the final device is packaged, and
the temperature sensor is disposed in a package that includes the final stage device.

2. The oscillator according to claim 1, wherein the final stage device and the temperature sensor are integrated into a single chip.

3. The oscillator according to claim 1 or 2, further comprising:
a directional coupler that is disposed between the final stage device and an output terminal of the oscillator, the directional coupler outputting, to the output terminal, the output power provided by the final stage device, the directional coupler receiving reflected power that is in accordance with a reflected wave that returns to the output terminal among the output power;
an output power detector that is connected to the directional coupler to detect the output power; and
a reflected power detector that is connected to the directional coupler to detect the reflected power.

4. The oscillator according to claim 1, further comprising:
an output power detector that detects the output power provided by the final stage device;
a storage that stores relationship information that indicates a relationship between the reflected power and a temperature rise of the final stage device with the temperature of the final stage device detected by the temperature sensor and the output power detected by the output power detector as parameters; and
a power estimator that estimates a value of the reflected power based on the relationship information.

5. The oscillator according to claim 1, further comprising:
a signal generation controller that controls the signal generator,
wherein the signal generator is operable to perform at least one of frequency control, phase control, or amplitude control on the oscillation signal, and
the signal generation controller causes the signal generator to stop generating the oscillation signal, or perform at least one of the frequency control, the phase control, or the amplitude control on the oscillation signal, based on at least a temperature detected by the temperature sensor.

6. The oscillator according to claim 1, further comprising:
a switching unit that turns on or off a function of the final stage device,
wherein the switching unit is disposed in the package.

7. The oscillator according to claim 6,
wherein the switching unit, the final stage device, and the temperature sensor are integrated into a single chip.

8. The oscillator according to claim 6 or 7, further comprising:
an output controller that controls the switching unit based on at least the temperature detected by the temperature sensor.

9. The oscillator according to any one of claims 1 to 8,
wherein the final stage device is a gallium oxide device.

10. An electric device comprising:
the oscillator according to any one of claims 1 to 9,
an antenna that radiates the output wave provided by the oscillator; and
a cavity that accommodates a heating target object.
